# EUROPEAN PATENT APPLICATION

(11) **EP 0 864 926 A1**
(43) Date of publication of application: **16.09.1998**
(21) Application number: 95942626.3
(22) Date of filing: 13.03.1995
(51) Int. Cl.: G03F 7/027

(54) **PHOTOSENSITIVE RESIN COMPOSITION, AND COATING FILM, RESIST INK, RESIST, SOLDER RESIST AND PRINTED CIRCUIT BOARD EACH PRODUCED THEREFROM**

(71) Applicant: Goo Chemical Industries Co.,Ltd., Kyoto 611 (JP)
(72) Inventor: HASHIMOTO, Soichi, Goo Chemical Industries Co. Ltd, Kyoto 611 (JP); SUZUKI, Fumito, Goo Chemical Industries Co., Ltd., Uji-shi, Kyoto 611 (JP)
(74) Representative: Brooks, Nigel Samuel
(86) International application number: JP9500414
(87) International publication number: WO9628764

(57) **Abstract**

Provided are a dilute-alkali-developable, photosensitive resin composition which is not sticky even in contact exposure to be conducted within a short period of pre-curing time and which has a lot of latitude in pre-curing time, and a film to be produced by coating the composition on a substrate followed by curing it. Also provided are a resist ink, a resist and a printed circuit board produced by using composition.

The photosensitive resin composition comprises;
A. an ultraviolet-curable resin having a weight-average molecular weight of from 6,000 to 30,000, which is obtained by reacting a polymer comprising (a) from 60 to 100 mol% of glycidyl (meth)acrylate and (b) from 0 to 40 mol% of other ethylenically unsaturated monomer(s) copolymerizable with (a), with from 0.7 to 1.2 chemical equivalents, relative to one epoxy equivalent of the polymer, of (meth)acrylic acid and with a saturated or unsaturated, polybasic acid anhydride,
B. a photo-polymerization initiator,
C. a diluent, and
D. a thermo-setting component.

## Description

### TECHNICAL FIELD

The present invention relates to an ultraviolet-curable photosensitive resin composition which is developable with a dilute alkali and also to a film, a resist ink, a resist, a solder resist and a printed circuit board produced by using said composition.

### BACKGROUND ART

Recently, methods of employing dry films or liquid, developable resist inks with high resolution and dimensional accuracy have become most popularized, in place of screen-printing methods, for forming resist patterns on various printed circuit boards for domestic use and industrial use to cope with the ever-increasing wiring density on printed circuit boards.

As examples of such resist inks, compositions containing as the essential ingredient ultraviolet-curable resins to be produced by reacting an epoxy resin with an unsaturated monocarboxylic acid while adding a poly-basic acid anhydride thereto are disclosed in Japanese Patent Publication Nos. 56-40329 and 57-45785. In Japanese Patent Laid-Open No. 61-243869, disclosed are dilute-alkali-developable, photosensitive resin compositions for resist inks comprising an ultraviolet-curable resin which is developable with a dilute aqueous solution of an alkali and which is obtained by adding an acid anhydride to a novolak-type epoxy acrylate, a photo-polymerization initiator, a diluent and a thermosetting component comprising an epoxy compound.

Resist inks comprising such ultraviolet-curable resins of novolak-type epoxy acrylate adducts with polybasic acid anhydrides can finally give considerably good resists. Since the resists have excellent physical properties suitable as solder resists, the above-mentioned ultraviolet-curable resins are much used in solder resist inks. However, the ultraviolet-curable resin compositions comprising novolak-type epoxy acrylate resins are highly sticky, since the novolak-type epoxy resins which are the raw materials for ultraviolet-curable resin compositions contain oligomer components having a relatively low molecular weight. At present, the problem in the stickiness of the resin compositions has been tried to be solved by employing high-molecular-weight epoxy resins. However, the molecular weight of popular novolak-type epoxy resins which can be provided as the raw materials for the ultraviolet-curable resin compositions is limited and it is difficult to provide novolak-type epoxy resins having a molecular weight of 10,000 or more as the raw materials for the ultraviolet-curable resin compositions. For these reasons, therefore, it is in fact impossible to solve the problem in the stickiness of the ultraviolet-curable resin compositions. Even though so-called, mono-dispersed novolak-type epoxy resins from which low-molecular-weight oligomers have been removed are used as the raw materials, or even though the final formulation of the components constituting the compositions is modified, it is still impossible to eliminate the stickiness of the compositions. Accordingly, the drawback of the ultraviolet-curable compositions in their stickiness is inevitable and is intrinsic to the compositions, as far as novolak epoxy resins are used as the raw materials for the compositions. The stickiness of the compositions is the most critical factor that controls and rather lowers the producibility of printed circuit boards in the step of producing the boards by the use of resist inks as finally formulated from the ultraviolet-curable resin compositions comprising novolak epoxy resins.

To form a resist pattern on a substrate by the use of a resist ink, in general, either a contact exposure method or an off-contact exposure method is employed. The former contact exposure method is preferred to the latter in order to form a more accurate resist pattern having a sharp edge-shaped profile. The contact exposure method comprises applying a resist ink to a substrate by dipping, spraying, spin-coating, roll-coating, screen-printing or the like, then pre-curing it, for example, at from 60 to 120°C so as to vaporize the organic solvent used as the diluent for the ink, then applying a patterned negative mask to the surface of the dried film formed on the substrate in such a way that the mask is in direct contact with the dried film, exposing the thus-masked film to ultraviolet rays by the use of a chemical lamp, a low-pressure mercury lamp, a middle-pressure mercury lamp, a high-pressure mercury lamp, an ultra-high-pressure mercury lamp, a xenon lamp, a metal halide lamp or the like, and thereafter developing it to produce the intended pattern on the substrate. In this method, if the pre-cured film, with which a patterned negative mask shall be in direct contact, is sticky, such causes various problems in that a mark made by the contacted negative mask remains in the exposed film, that the mask is difficult to peel and that the mask is stained to shorten its life and to lower its resolution.

Novolak-type epoxy acrylate resist inks are highly sticky as so mentioned hereinabove, and the stickiness of the resist film comprising the ink cannot be lowered to a practicable level if the evaporation and removal of the organic solvent used as the diluent cannot be completed as much as possible during pre-curing the ink film. The reason is considered because the novolak-type epoxy acrylate components having a relatively low molecular weight in the ink film would be plasticized during the pre-curing by even a minor amount of the solvent remained therein. For this reason, the pre-curing must be conducted generally for 40 minutes or so at 70°C. However, such is a serious problem in view of the producibility of resist patterns on substrates. If the problem is not solved, it is impossible to significantly improve the producibility in question.

Given the situation, it may be considered to use a poorly-sticky polymer of ethylenically unsaturated monomers such as (meth)acrylic or styrenic monomers, along with a polymer binder which has carboxyl group(s) and which is therefore re-dispersible in a dilute, alkaline aqueous solution and also with a diluent selected from acrylic monomers and the like. The photo-curability of the composition comprising these is derived from only the diluent. As examples of the composition of this type, there are mentioned radiation-curable mixtures such as those described in Japanese Patent Laid-Open No. 58-42040. In these mixtures, however, the polymer binder itself is not photo-curable. Therefore, even when these mixtures are used to produce resist inks, the resulting resist inks are not satisfactorily photo-curable to give sharp patterns. The patterns made by the use of such resist inks often have additional problems in that these are swollen or peeled during development. In addition, since the resist inks are not satisfactorily photo-curable, these rather have disadvantages in that much thermo-setting components must be added thereto in order to maintain the physical properties of the resulting resists and that the allowable range for the pre-curing time is narrowed.

According to the method of producing the above-mentioned ultraviolet-curable resins of novolak-type epoxy acrylate adducts with polybasic acid anhydrides, it is possible to obtain similar ultraviolet-curable resins by adding a (meth)acrylic acid to a vinyl copolymer comprising, as one monomer unit, an ethylenically unsaturated monomer having epoxy group(s) such as glycidyl (meth)acrylate, followed by further adding a polybasic acid anhydride thereto. According to this method, for example, ultraviolet-curable resins are obtainable from alkyl acrylate copolymers. (These are hereinafter referred to as "ultraviolet-curable, acrylic polybasic acid anhydride adduct resins".) As compared with the above-mentioned ultraviolet-curable, novolak-type epoxy acrylate resins, these ultraviolet-curable, acrylic polybasic acid anhydride adduct resins have a lot of latitude in selecting the molecular weights of the constitutive components, the softening point of themselves and the epoxy content of the copolymers constituting them. In the latter, therefore, these factors can be suitably selected in accordance with the intended object.

Heretofore, it has been said that when such ultraviolet-curable, acrylic polybasic acid anhydride adduct resins are applied to dilute-alkali-developable solder resist inks, the amount of the unsaturated monomer having epoxy group(s) shall be not larger than 60 mol% of the total amount of the monomers constituting the raw material of the acrylate polymer. This may be presumed because acrylic polymers that are popularly used in coating materials for industrial use have a molecular weight of approximately from 40,000 to 200,000 and therefore the optimum content of the unsaturated monomer having epoxy group(s) to be in the acrylic polymers having a molecular weight falling within the range was determined. Therefore, the ultraviolet-curable resins to be obtained from the raw materials of such acrylic polymers must have a relatively high molecular weight in accordance with this.

It may be said that the ultraviolet-curable resins having such a relatively high molecular weight may have a high sensitivity in point of the fact that their re-solubility in dilute alkalis is lowered even by minor exposure of the resins. However, if the resin is applied to a substrate and then a negative mask is attached thereto, the resin resist formed on the substrate is sensitive even to minor light as leaked through the boundary of tha pattern in the negative mask. As a result, the change in the re-solubility and the dispersibility in dilute alkalis of the boundary between the exposed area and the non-exposed area becomes dull as a whole, and it becomes difficult to form a resist pattern having a sharp edge profile from the resist film. In other words, the apparent sensitivity of the resist is increased but the latitude in exposure thereof is narrowed with the result that the sufficient amount of exposure enough to maintain the resolution of the resist film is lowered as a whole. The latitude in exposure as referred to herein indicates the range of the sufficient amount of exposure enough to make the exposed resist film maintain satisfactory resolution.

If the resolution of the resist film is desired to be increased, the photo-curing of the exposed area of the film shall naturally be incomplete, thereby directly resulting in the worsening of the physical properties of the solder resist itself. Therefore, even if the molecular weight of the ultraviolet-curable resin is enlarged, such causes only the increase in the apparent sensitivity of the resin but does not attain the increase in the substantial sensitivity thereof. In fact, the solder resist produced from the resist ink comprising the ultraviolet-curable, acrylic polybasic acid anhydride adduct resin that falls within the above-mentioned numerical range is much inferior to that produced from the resist ink comprising the other ultraviolet-curable, novolak-type epoxy acrylate resin with respect to the heat resistance in soldering and the gold plating resistance. As a result, it is inevitable that the former solder resist is often whitened or peeled. For these reasons, it was difficult to use the ultraviolet-curable, acrylic polybasic acid anhydride adduct resins to produce solder resist inks for printed circuit boards for industrial use and those for domestic use if such printed circuit boards are required to have high quality.

Because of the reasons as mentioned above, either the acrylic solder resist inks or the novolak solder resist inks shall be selected at present in accordance with the level of the necessary physical properties of the printed circuit boards to be produced, in such a way that the former are selected if the producibility of the products is considered predominant over others while the latter are selected if the final physical properties of the resists are considered predominant over others.

The subject matter of the present invention is to provide a dilute-alkali-developable, photosensitive resin composition which is not sticky even in contact exposure to be conducted within a short period of pre-curing time and which has a lot of latitude in pre-curing time, and also to provide a film to be produced by coating the composition on a substrate followed by curing it. Another subject matter of the present invention is to provide a resist ink comprising the photosensitive resin composition, and also a resist, especially a solder resist, as formed on a substrate by coating the composition thereon, which can be exposed even within a short period of time to give a resist film having good chemical resistance, solvent resistance, gold-plating resistance and heat resistance. Still another subject matter of the present invention is to provide a printed circuit board as produced by the use of the resist ink.

### DISCLOSURE OF THE INVENTION

The photosensitive resin composition of the present invention which is developable with a dilute, alkaline aqueous solution comprises;
A. an ultraviolet-curable resin having a weight-average molecular weight of from 6,000 to 30,000, which is obtained by reacting a polymer comprising (a) from 60 to 100 mol% of glycidyl (meth)acrylate and (b) from 0 to 40 mol% of other ethylenically unsaturated monomer(s) copolymerizable with (a), with from 0.7 to 1.2 chemical equivalents, relative to one epoxy equivalent of the polymer, of (meth)acrylic acid and with a saturated or unsaturated, polybasic acid anhydride,
B. a photo-polymerization initiator,
C. a diluent, and
D. a thermo-setting component.

### A. Ultraviolet-curable Resin:

The ultraviolet-curable resin to be used in the present invention is obtained by reacting a polymer comprising (a) from 60 to 100 mol% of glycidyl (meth)acrylate and (b) from 0 to 40 mol% of other ethylenically unsaturated monomer(s) copolymerizable with (a), with from 0.7 to 1.2 chemical equivalents, relative to one epoxy equivalent of the polymer, of (meth)acrylic acid and with a saturated or unsaturated, polybasic acid anhydride.

The glycidyl (meth)acrylate of the component (a) is in the polymer, by which the polymer shall have glycidyl groups. The addition of (meth)acrylic acid to the polymer having such glycidyl groups results in the introduction of ethylenically unsaturated double bonds into the polymer, by which the polymer is made to be ultraviolet-curable. The content of the glycidyl (meth)acrylate of the component (a) in the polymer must be from 60 to 100 mol% of all the unsaturated monomers constituting the polymer. In addition, the ultraviolet-curable resin must have a weight-average molecular weight of from 6,000 to 30,000, especially preferably from 10,000 to 25,000.

The ultraviolet-curable resin must satisfy both the proportions of the constitutive components as mentioned above and the mean molecular weight also mentioned above because of the following reasons. In order to attain the object of the present invention, the resist ink comprising the photosensitive resin composition of the invention must have high resolution and also a high sensitivity while maintaining a lot of latitude in its exposure. Only if so, the resist ink is characterized in that the exposed area of the resist can be cured sufficiently while the removal of the area by development is not retarded even when the resist is cured only slightly by the leakage of a minor amount of light through the boundary of the pattern in the negative mask attached. Since the exposed area of the resist can be cured sufficiently, the object of the present invention is realized which is to make the resist have excellent heat resistance in soldering, chemical resistance, solvent resistance, gold-plating resistance and heat resistance.

However, if an ultraviolet-curable resin having a mean molecular weight of larger than 30,000 is used in the photosensitive resin composition, the solubility in a dilute alkali solution of the resist ink comprising the composition is noticeably lowered even when the resist formed from the ink is exposed to an extremely low degree. This is because the resin having such a large mean molecular weight is not sufficiently soluble in a dilute, aqueous alkaline solution even when it is not exposed, and, in addition, the molecular weight of the resin is rapidly increased even when the ethylenically unsaturated groups in the resin molecules are only slightly influenced by photo-polymerization reaction. This results from the experiential fact that, for ultraviolet-curable resins having the same content of ethylenically unsaturated bonds therein, provided that the content of ethylenically unsaturated bonds in the resins is represented by the percentage relative to one kg of the resin, the increase in the molecular weight of the resin to be caused by exposure depends on the molecular weight itself of the non-exposed resin and that the larger the molecular weight, the larger the increase in the molecular weight like a so-called quadratic curve.

Therefore, the removability by development of a resist formed from a resist ink comprising an ultraviolet-curable resin having a weight-average molecular weight of larger than 30,000 is lowered even by the curing of the resin due to a minor amount of light as leaked through the boundary of pattern in the negative mask as attached. For this reason, the content of ethylenically unsaturated groups in such a resin must be lowered to ensure the necessary latitude in exposure in order that the resist comprising the resin is made to maintain the necessary resolution. As a result of the reduction in the content in question, however, the exposed area of the resist could not be cured sufficiently and therefore, the resist could not finally have satisfactory physical properties in such a degree that it meets high-degree requirements.

In view of the above-mentioned problems, the ultraviolet-curable resin for use in the present invention is defined to have a weight-average molecular weight of 30,000 or lower, while the content of ethylenically unsaturated groups in the resin is enlarged as much as possible. Concretely, the content of the glycidyl (meth)acrylate monomer in the raw material polymer shall be not lower than 60 mol%, preferably not lower than 63 mol% of all the monomers constituting the polymer, by which the polymer shall have pendant, ethylenically unsaturated bonds. Accordingly, using the ultraviolet-curable resin having such a high content of ethylenically unsaturated groups as above, it is possible to formulate a resist ink to be able to give a resist, of which the removability by development is not lowered even when the molecular weight of the resin in the resist is increased in some degree due to minor exposure of the resist. The resist thus has a lot of latitude in exposure and has an excellent sensitivity and resolution at the suitably exposed area thereof due to the presence of a sufficient amount of ethylenically unsaturated groups therein.

For the reasons as mentioned above, the resist to be formed from the resist ink of the present invention can be satisfactorily photo-cured and therefore has excellent physical properties. Especially for solder resists comprising the resist ink of the invention, the noticeable improvement in the heat resistance thereof in soldering can be realized. In addition, since the ultraviolet-curable resin for use in the present invention has such a low molecular weight as mentioned above and is therefore near to an acrylic dispersant, its ability to disperse pigments therein is good. Therefore, the final composition comprising the resin has excellent storage stability.

The polymer can be obtained by any known polymerization, for example, by solution polymerization, emulsion polymerization or the like. Solution polymerization to prepare the polymer is referred to herein as one example. A mixture of unsaturated monomers comprising the above-mentioned components (a) and (b) is polymerized, for example, by a method of stirring the mixture under heat in a suitable organic solvent in the presence of a polymerization initiator in a nitrogen stream or by a boiling polymerization method to be conducted in the same manner.

The organic solvent includes, for example, ketones such as methyl ethyl ketone, cyclohexanone, etc.; aromatic hydrocarbons such as toluene, xylene, etc.; acetates such as ethyl acetate, butyl acetate, cellosolve acetate, butylcellosolve acetate, butylcarbitol acetate, propylene glycol monomethyl ether acetate, etc.; dialkylene glycol ethers, etc. These organic solvents can be used singly or as their mixtures.

The polymerization initiator includes, for example, hydroperoxides such as diisopropylbenzene hydroperoxide, cumene hydroperoxide, t-butyl hydroperoxide, etc.; dialkyl peroxides such as dicumyl peroxide, 2,5-dimethyl-2,5-di-(t-butylperoxy)-hexane, 1,3-bis(t-butylperoxyisopropyl)-benzene, t-butylcumyl peroxide, di-t-butyl peroxide, 2,5-dimethyl-2,5-di-(t-butylperoxy)-hexyne-3, etc.; diacyl peroxides such as isobutyryl peroxide, 2,4-dichlorobenzoyl peroxide, lauroyl peroxide, benzoyl peroxide, acetyl peroxide, etc.; ketone peroxides such as methyl ethyl ketone peroxide, methyl isobutyl ketone peroxide, cyclohexanone peroxide, acetylacetone peroxide, etc.; alkyl peresters such as t-butylperoxy pivalate, t-butylperoxy 2-ethylhexanoate, t-butylperoxy 3,5,5-trimethylhexanoate, t-butylperoxy acetate, t-butylperoxy benzoate, etc.; peroxy dicarbonates such as diisoprpylperoxy dicarbonate, di-2-ethylhexylperoxy dicarbonate, diisopropylperoxy dicarbonate, di-sec-butylperoxy dicarbonate, etc.; azo compounds such as azobisisobutyronitrile, methyl 2,2'-azobisisobutyrate, azobiscyanovaleronitrile, 1,1'-azobis(cyclohexene-1-carbonitrile), 2,2'-azobis{2-methyl-N-(2-hydroxyethyl)propionamide}, etc.

It is required that the molecular weight of the polymer shall accord with the necessary molecular weight of the ultraviolet-curable resin to be obtained by the use of the polymer. Therefore, in order to obtain the polymer having such a relatively low molecular weight, employable are halide chain transfer agents such as alkyl halides, polyhalides, bromophenacyldimethylsulfoniumylides, etc.; sulfur compound chain transfer agents such as thiols (e.g., alkylmercaptans, thioglycols, glycol dimercaptoacetates, etc.), thiocarboxylic acids (e.g., thiomalic acids, etc.), dithiocarbamidates, thioamides, thioureas, etc.; terpenoid chain transfer agents such as limonenes, etc.; dimer chain transfer agents such as α-methylstyrene dimers, etc.; addition-cleaving chain transfer agents such as α-benzyloxy-substituted vinyl monomers, etc.; ylide chain transfer agents such as sulfoniumylides, etc. Also employable are high-temperature polymerization, pressure polymerization, etc. Anyhow, the polymerization conditions for producing the polymer must be such that the epoxy groups in the monomers are not cleaved during the polymerization.

The component (b) may comprise any ethylenically unsaturated monomer that can be copolymerized with the component (a). For example, it includes linear, branched or alicyclic alkyl (meth)acrylates such as methyl (meth)acrylate, ethyl (meth)acrylate, propyl (meth)acrylate, butyl (meth)acrylate, isobutyl (meth)acrylate, tert-butyl (meth)acrylate, 2-ethylhexyl (meth)acrylate, n-octyl (meth)acrylate, n-decyl (meth)acrylate, isodecyl (meth)acrylate, lauryl (meth)acrylate, myristyl (meth)acrylate, cetyl (meth)acrylate, stearyl (meth)acrylate, cyclohexyl (meth)acrylate, isobornyl (meth)acrylate, etc.; ethylene glycol (meth)acrylates such as hydroxyethyl (meth)acrylate, methoxyethyl (meth)acrylate, ethoxyethyl (meth)acrylate, diethylene glycol mono(meth)acrylate, triethylene glycol mono(meth)acrylate, methoxydiethylene glycol (meth)acrylate, etc., and the corresponding propylene glycol (meth)acrylates, butylene glycol mono(meth)acrylates and glycerol mono(meth)acrylates; aromatic (meth)acrylates such as benzyl (meth)acrylate, etc.; acrylamides such as (meth)acrylamide, N-methyl(meth)acrylamide, N-propyl(meth)acrylamide, N-tert-butyl(meth)acrylamide, N-tert-octyl(meth)acrylamide, diacetone (meth)acrylamide, etc.; as well as vinyl pyrrolidone, acrylonitrile, vinyl acetate, styrene, α-methylstyrene, vinyl ether, etc. These can be used singly or as their mixtures. These are used in order to control the content of ethylenically unsaturated groups to be introduced into the final ultraviolet-curable resin, the hardness of the pre-cured film and the hardness of the final resist, or in order to control the workability, such as the dispersibility, the solubility and the printability, of the resist ink in its actual use.

The amount of the (meth)acrylic acid to be added to the polymer shall be from 0.7 to 1.2 chemical equivalents relative to one epoxy equivalent of the polymer or, that is, shall be from 0.7 to 1.2 chemical equivalents relative to the glycidyl (meth)acrylate in the polymer. If it is less than 0.7 chemical equivalents, too many glycidyl groups remain in the ultraviolet-curable resin and are cured at the pre-curing step, thereby often lowering the developability of the exposed resist. If, on the other hand, the amount is more than 1.2 chemical equivalents, the existence of the non-reacted (meth)acrylic acid in the resin is problematic.

The saturated or unsaturated, polybasic acid anhydride for use in the present invention includes, for example, dibasic acid anhydrides such as succinic anhydride, methylsuccinic anhydride, maleic anhydride, citraconic anhydride, glutaric anhydride, itaconic anhydride, phthalic anhydride, tetrahydrophthalic anhydride, methyltetrahydrophthalic anhydride, methylnadic anhydride, hexahydrophthalic anhydride, methylhexahydrophthalic anhydride, etc.; and tri-basic or higher poly-basic acid anhydrides such as trimellitic acid anhydride, pyromellitic acid anhydride, benzophenone-tetracarboxylic acid anhydride, methylcyclohexene-tetracarboxylic acid anhydride, etc.

The acid anhydride is used essentially for the purpose of imparting an acid value to the ultraviolet-curable resin to thereby make the resin re-dispersible and re-soluble in dilute, aqueous alkaline solutions. Therefore, the acid anhydride is added to the polymer by which the ultraviolet-curable resin is made to have an acid value of preferably from 25 to 150. When the resin has an acid value of from 40 to 100, the most favorable results are realized. If the acid value of the resin is less than 25, the developability of the resist comprising the resin is poor. However if it is more than 150, the carboxyl groups still remained in the cured resist cause various problems in that the electric characteristics, the electro-etchability and the water resistance of the cured resist are worsened. These problems are of critical importance for solder resists.

The addition of the (meth)acrylic acid and the saturated or unsaturated, polybasic acid anhydride to the polymer can be conducted by any known method. To add the (meth)acrylic acid to the polymer, for example, the both are reacted by ordinary methods at from 50 to 150°C, especially preferably from at 60 to 120°C, by adding a thermal polymerization inhibitor such as hydroquinone, hydroquinone monomethyl ether or the like, a tertiary amine such as benzyldimethylamine, triethylamine or the like, a quaternary ammonium salt such as trimethylbenzylammonium chloride, methyltriethylammonium chloride or the like and/or a catalyst such as triphenylstibine, to the solution of the polymer in a solvent. The addition of the saturated or unsaturated, polybasic acid anhydride is conducted in the same manner.

It is desirable that the amount of the ultraviolet-curable resin to be in the photosensitive resin composition of the present invention is from 2 to 60 % by weight of the total amount of the composition.

### B. Photo-polymerization Initiator:

The photo-polymerization initiator for use in the present invention includes, for example, benzoin and its alkyl ethers such as benzoin, benzoin methyl ether, benzoin ethyl ether, benzoin isopropyl ether, etc.; acetophenones such as acetophenone, 2,2-dimethoxy-2-phenylacetophenone, 2,2-diethoxy-2-phenylacetophenone, 1,1-dichloroacetophenone, 1-hydroxycyclohexyl phenyl ketone, etc.; anthraquinones such as 2-methylanthraquinone, 2-amylanthraquinone, etc.; thioxanthones such as 2,4-dimethylthioxanthone, 2,4-diethylthioxanthone, 2-chlorothioxanthone, 2,4-diisopropylthioxanthone, 1-chloro-4-propoxythioxanthone, etc.; ketals such as acetophenone dimethylketal, benzyldimethylketal, etc.; benzophenones and xanthones such as benzophenone, 3,3-dimethyl-4-methoxybenzophenone, 3,3',4,4'-tetra-(t-butylperoxycarbonyl)benzophenone, 4-benzoyl-4'-methyldiphenylsulfide, etc.; nitrogen-containing compounds such as 2-methyl-1-[4-(methylthio)phenyl]-2-morpholino-propan-1-one, 2-benzoyl-2-dimethylamino-1-(4-morpholinophenyl)butanone-1, 4,4'-bis-diethylaminobenzophenone, etc.; as well as "Lucirin TPO" (ex BASF; 2,4,6-trimethylbenzoyldiphenylphosphine oxide), etc. These can be used along with known photo-polymerization promoters, for example, benzoic acids, tertiary amines such as ethyl p-dimethylaminobenzoate, isoamyl p-dimethylaminobenzoate, 2-dimethylaminoethyl benzoate, etc. Any of these photo-polymerization initiators is added, either singly or as their mixture, to the composition of the present invention preferably at a proportion of from 0.1 to 30 % by weight, more preferably from 0.5 to 25 % by weight, relative to the whole amount of the ultraviolet-curable components in the composition.

### C. Diluent:

As the diluent, usable is/are a photo-polymerizable monomer or/and an organic solvent, either singly or as their mixture. The photo-polymerizable monomer includes, for example, water-soluble monomers such as 2-hydroxyethyl acrylate, 2-hydroxypropyl acrylate, N-vinylpyrrolidone, acryloyl morpholine, methoxytetraethylene glycol acrylate, methoxypolyethylene glycol acrylate, polyethylene glycol diacrylate, N,N-dimethylacrylamide, N-methylolacrylamide, N,N-dimethylaminopropylacrylamide, N,N-dimethylaminoethyl acrylate, N,N-dimethylaminopropyl acrylate, melamine acrylate, and methacrylates corresponding to these acrylates; water-insoluble monomers such as diethylene glycol diacrylate, triethylene glycol diacrylate, propylene glycol diacrylate, tripropylene glycol diacrylate, phenoxyethyl acrylate, tetrahydrofurfuryl acrylate, cyclohexyl acrylate, trimethylolpropane diacrylate, trimethylolpropane triacrylate, pentaerythritol triacrylate, pentaerythritol tetraacrylate, dipentaerythritol pentaacrylate, dipentaerythritol hexaacrylate, isobornyl acrylate, cyclopentanyl (mono or di)acrylate, cyclopentenyl (mono or di)acrylate, methacrylates corresponding to these acrylates, mono-, di-, tri- or higher poly-esters of polybasic acids and hydroxyalkyl (meth)acrylates, etc.; high-molecular-weight acrylate monomers, for example, epoxyacrylates such as bisphenol A-type epoxyacrylates, phenol-novolak-type epoxyacrylates, cresol-novolak-type epoxyacrylates, etc. (these epoxyacrylates may be partly crosslinked with compounds having at least two isocyanato groups in the molecule or with polybasic acid anhydrides, etc.), polyester acrylates, urethane acrylates, etc. These water-soluble monomers, water-insoluble monomers and high-molecular-weight acrylate monomers can be used singly or as their mixtures.

The organic solvent includes, for example, linear, branched, secondary or polyhydric alcohols such as ethanol, propanol, isopropanol, butanol, isobutanol, 2-butanol, hexanol, ethylene glycol, etc.; ketones such as methyl ethyl ketone, cyclohexanone, etc.; aromatic hydrocarbons such as toluene, xylene, etc.; cellosolves such as cellosolve, butyl cellosolve, etc.; carbitols such as carbitol, butyl carbitol, etc.; propylene glycol alkyl ethers such as propylene glycol methyl ether, etc.; polypropylene glycol alkyl ethers such as dipropylene glycol methyl ether, etc.; acetates such as ethyl acetate, butyl acetate, cellosolve acetate, butylcellosolve acetate, butylcarbitol acetate, propylene glycol monomethyl ether acetate, etc.; dialkylene glycol ethers, etc.

The photo-polymerizable monomers such as the above-mentioned water-soluble monomers, water-insoluble monomers and high-molecular-weight acrylate monomers dilute the polymer and other components constituting the composition of the present invention to thereby make the composition easily coatable, while controlling the acid value of the composition and making the composition photo-polymerizable. The above-mentioned organic solvent dissolves and dilutes the polymer and other components to liquefy the composition and therefore make the composition coatable. In addition, the solvent existing in the composition is removed by drying the composition as coated on a substrate, whereby a film is formed from the composition on the substrate. Depending on the coating method, it is desirable that the diluent is, either singly or as a mixture of two or more, in the photosensitive composition of the present invention at a proportion of from 10 to 95 % by weight relative to the total amount of the composition.

### D. Thermo-setting Component:

The thermo-setting component is added to the composition of the present invention for the purpose of improving the density of cross-links in the resist to be formed from the composition and also of reacting with the carboxyl groups resulting from the ultraviolet-curable resin in the composition. As examples of the thermo-setting component, mentioned are thermo-setting epoxy compounds; blocked isocyanates such as tolylene diisocyanate, morpholine diisocyanate, isophorone diisocyanate and hexamethylene diisocyanate as blocked with caprolactams, oximes, malonates, etc.; amino resins such as n-butylated melamine resins, isobutylated melamine resins, butylated urea resins, butylated melamine-urea copolycondensate resins, benzoguanamine copolycondensate resins, etc.

Of these, especially preferred are thermo-setting epoxy compounds. The thermo-setting epoxy compounds include, for example, bisphenol A-type epoxy resins, bisphenol F-type epoxy resins, phenol-novolak-type epoxy resins, cresol-novolak-type epoxy resins, N-glycidyl epoxy resins, alicyclic epoxy resins (e.g., "EHPE-3150" ex Daisel Co.); "YX-4000" (ex Yuka Shell Epoxy Co.; epoxy resin); hydrogenated bisphenol A-type epoxy resins; triglycidyl isocyanurate, etc. Of these, especially favorable are triglycidyl isocyanurate, "YX-4000" and cresol-novolak-type epoxy resins.

The photosensitive resin composition of the present invention may contain, in addition to the above-mentioned components, various polymer compounds, for example, ultraviolet-curable epoxy acrylates (e.g., bisphenol A-type, phenol-novolak-type, cresol-novolak-type or alicyclic epoxy resins added with (meth)acrylic acid) and those as further added with saturated or unsaturated polybasic acid anhydrides such as maleic anhydride, succinic anhydride, itaconic anhydride, phthalic anhydride, tetrahydrophthalic anhydride, etc.; copolymers of ethylenically unsaturated compounds such as styrene-(meth)acrylic acid-(meth)acrylate copolymers, etc. and ultraviolet-curable polymers to be obtained by further reacting those with ethylenically unsaturated monomers having epoxy group(s); ultraviolet-curable polymers to be obtained by adding (meth)acrylic acids to vinyl copolymers comprising, as one monomer unit, an ethylenically unsaturated monomer having epoxy group(s); and also other styrene-maleic acid resins, diallyl phthalate resins, phenoxy resins, melamine resins, urethane resins, fluorine resins, etc.

In addition, the photosensitive resin composition may further contain, if desired, epoxy resin curing agent and curing promoters such as imidazole derivatives, polyamines, guanamines, tertiary amines, quaternary ammonium salts, polyphenols, polybasic acid anhydrides, etc.; fillers such as barium sulfate, silicon oxide, talc, clay, calcium carbonate, etc.; colorants; leveling agents such as silicones, acrylate copolymers, fluorine-containing surfactants, etc.; adhesiveness improving agents such as silane coupling agents; thixotropic agents such as aerogel, etc.; polymerization inhibitors such as hydroquinone, hydroquinone monomethyl ether, pyrogallol, tert-butyl catechol, phenothiazine, etc.; other various additives such as anti-halation agents, flame retardants, de-foaming agents, antioxidants, etc.; and also surfactants and polymer dispersants to improve the dispersion stability of the composition, etc.

The photosensitive resin composition of the present invention can be produced by known kneading methods where the constitutive components and additives are kneaded in a three-stage roll mill, ball mill, sand mill or the like. If desired, it is also possible that a part of the above-mentioned components A to D, for example, the components A and C are previously mixed and dispersed and the remaining components are added to the resulting mixture to finally produce the photosensitive resin composition of the invention just before use.

The photosensitive resin composition of the present invention can be used not only as a solder resist ink but also as an etching resist. In the latter case, the composition is not post-cured under heat. A composition comprising the above-mentioned constitutive components for the photosensitive resin composition of the present invention, except the thermo-setting component such as thermo-setting epoxy compounds, can also be used as a solder resist ink favorably in some degree and can also be used as an etching resist ink. In addition, the composition comprising the same constitutive components as those for the photosensitive resin composition of the present invention, except the thermo-setting component, can be used for forming a color filer protecting film. If the composition of this type contains a suitable colorant of pigment or dye as selected from organic pigments such as azo-lake pigments, insoluble azo pigments, phthalocyanine pigments, etc., inorganic pigments such as Millon Blue, iron oxide, cobalt pigments, etc., as well as oil-soluble dyes, basic dyes, disperse dyes, etc., it can be used for forming color filter pixels.

### BEST MODES OF CARRYING OUT THE INVENTION

The present invention is described hereinunder on the basis of examples thereof, which, however, are not intended to restrict the scope of the present invention. All "parts" and "%" as referred to hereinunder are by weight.

### Production Examples 1 to 5:

70 parts of glycidyl methacrylate, 30 parts of methyl methacrylate, 100 parts of carbitol acetate, 0.2 parts of laurylmercaptan and 3 parts of azobisisobutyronitrile were put into a four-neck flask equipped with a reflux condenser, a thermometer, a glass tube for nitrogen substitution and a stirrer, and polymerized for 5 hours by heating at 75°C in a nitrogen stream to obtain a 50 % solution of a copolymer.

0.05 parts of hydroquinone, 37 parts of acrylic acid and 0.2 parts of dimethylbenzylamine were added to the 50 % copolymer solution and reacted for 24 hours at 100°C for addition reaction. Next, 45 parts of tetrahydrophthalic anhydride and 79 parts of carbitol acetate were added thereto and reacted for 3 hours at 100°C. Thus, a 50 % solution of an ultraviolet-curable resin (A-1) having a weight-average molecular weight of 26,000, a content of ethylenically unsaturated bonds of 2.82 and an acid value of 91, as shown in Table 1, was obtained. This is referred to as Production Example 1. Next, in the same manner as above, ultraviolet-curable resin solutions (A-2) to (A-5) were obtained as Production Examples 2 to 5, as in Table 1. The weight-average molecular weight as referred to herein is defined according to the manner mentioned below.

### Method of Defining Molecular Weight:

The molecular weights as referred to herein all indicate the weight-average molecular weights as measured by GPC. The conditions for the measurement are as follows: Conditions for Measurement of Molecular Weight:
GPC Device: SHODEX SYSTEM 11 ex Showa Denko Co.
Columns: Four columns of SHODEX KF-800P, KF-005, KF-003 and KF-001 as connected in series.
Mobile Layer: THF
Flow Rate: 1 ml/min
Column Temperature: 45°C
Detector: RI
Standard Substance: Polystyrene

### Referential Examples 1 to 4:

50 parts of glycidyl methacrylate, 50 parts of methyl methacrylate, 100 parts of carbitol acetate and 2 parts of azobisisobutyronitrile were put into a four-neck flask equipped with a reflux condenser, a thermometer, a glass tube for nitrogen substitution and a stirrer, and polymerized for 5 hours by heating at 75°C in a nitrogen stream to obtain a 50 % solution of a copolymer.

0.05 parts of hydroquinone, 26 parts of acrylic acid and 0.2 parts of dimethylbenzylamine were added to the 50 % copolymer solution and reacted for 24 hours at 100°C for addition reaction. Next, 10.7 parts of tetrahydrophthalic anhydride and 51 parts of carbitol acetate were added thereto and reacted for 3 hours at 100°C. Thus, a 50 % solution of an ultraviolet-curable resin (B-1) having a weight-average molecular weight of 35,000, a content of ethylenically unsaturated bonds of 2.36 and an acid value of 65, as shown in Table 1, was obtained. This is referred to as Referential Example 1. Next, in the same manner as above, ultraviolet-curable resin solutions (B-2) to (B-4) were obtained as Referential Examples 2 to 4, as in Table 1.

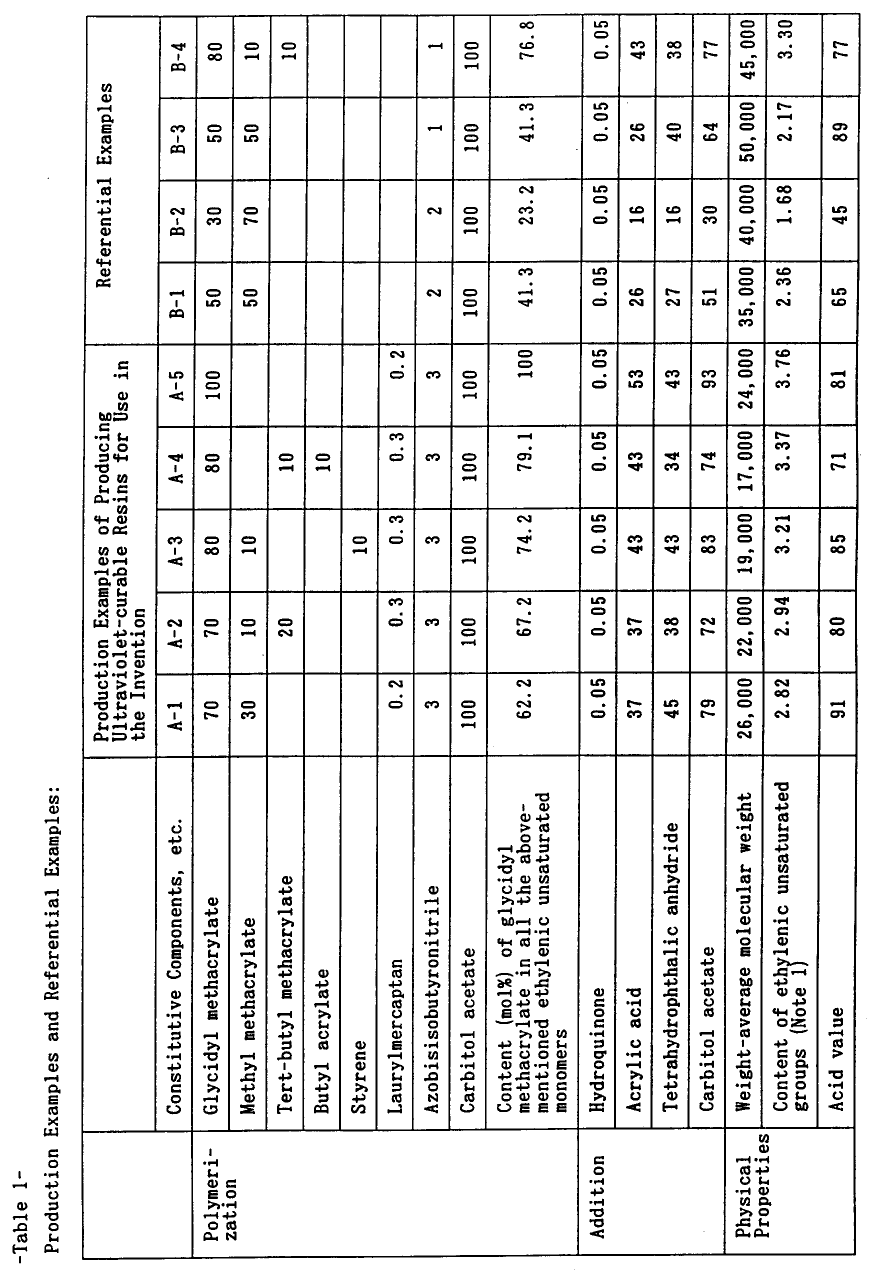

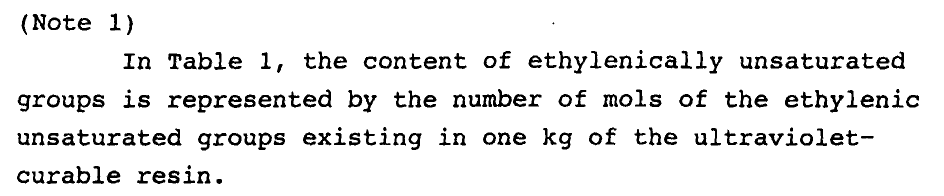

### Referential Example 5:

214 parts of Epicron N-680 (ex Dai-Nippon Ink Chemical Industry Co.; cresol-novolak-type epoxy resin having an epoxy equivalent of 214) was dissolved in 60 parts of carbitol acetate under heat. 74 parts of acrylic acid, 0.1 parts of hydroquinone and 1.4 parts of benzyldimethylamine were added to the resulting resin solution with stirring and reacted at from 90 to 100°C for 24 hours according to an ordinary method. 76 parts of tetrahydrophthalic anhydride was added to the resulting reaction product and reacted at 100°C for about 3 hours with stirring. Next, 137 parts of carbitol acetate was added thereto with stirring. Thus, a 50 % solution of an ultraviolet-curable resin (B-5) was obtained as Referential Example 5.

### Referential Example 6:

214 parts of Epicron N-680 (ex Dai-Nippon Ink Chemical Industry Co.; cresol-novolak-type epoxy resin having an epoxy equivalent of 214) was dissolved in 60 parts of carbitol acetate under heat. 74 parts of acrylic acid, 0.1 parts of hydroquinone and 0.7 parts of benzyldimethylamine were added to the resulting resin solution with stirring and reacted at from 90 to 100°C for 24 hours according to an ordinary method. 60 parts of carbitol acetate and 35 parts of butylcellosolve were added to the resulting reaction mixture, stirred and then cooled. Thus, a 50 % solution of epoxy acrylate (C-1) was obtained as Referential Example 6.

### Referential Example 7:

65 parts of glycidyl methacrylate, 35 parts of methyl methacrylate, 0.2 parts of laurylmercaptan, 100 parts of carbitol acetate and 3 parts of azobisisobutyronitrile were put into a four-neck flask equipped with a reflux condenser, a thermometer, a glass tube for nitrogen substitution and a stirrer, and polymerized for 5 hours by heating at 75°C in a nitrogen stream to obtain a 50 % solution of a copolymer.

0.05 parts of hydroquinone, 34 parts of acrylic acid and 0.2 parts of dimethylbenzylamine were added to the 50 % copolymer solution and reacted for 24 hours at 100°C for addition reaction. Next, 34 parts of carbitol acetate was added thereto and stirred. Thus, a 50 % solution of a resin (C-2) having a weight-average molecular weight of 22,000 was obtained as Referential Example 7.

### Examples 1 to 7 and Comparative Examples 1 to 7:

Using any of the resin solutions of the above-mentioned production examples and referential examples, the components as shown in Table 2 for Examples 1 to 7 or those as shown in Table 3 for Comparative Examples 1 to 7 were kneaded in a three-stage roll mill. Thus, dilute-alkali-developable, photosensitive resin compositions were obtained.

**Table 2**

| Formulations of Photosensitive Resin Compositions: | | | | | | | |
|---|---|---|---|---|---|---|---|
| Constitutive Components | Examples | | | | | | |
| | Photosensitive Resin Compositions of the Invention | | | | | | |
| | 1 | 2 | 3 | 4 | 5 | 6 | 7 |
| UV-curable resin solution (A-1) | 50 | | | | | | |
| UV-curable resin solution (A-2) | | 50 | | | | | |
| UV-curable resin solution (A-3) | | | 50 | | | 50 | |
| UV-curable resin solution (A-4) | | | | 50 | | | 50 |
| UV-curable resin solution (A-5) | | | | | 50 | | |
| UV-curable resin solution (B-1) | | | | | | | |
| UV-curable resin solution (B-2) | | | | | | | |
| UV-curable resin solution (B-3) | | | | | | | |
| UV-curable resin solution (B-4) | | | | | | | |
| UV-curable resin solution (B-5) | | | | | | | |
| Epoxy acrylate solution (C-1) | 5 | 8 | | 5 | 8 | 8 | |
| Resin solution (C-2) | | | 5 | | | | 8 |
| Dipentaerythritol hexaacrylate | 4 | 5 | 5 | 5 | 4 | 4 | 4 |
| TEPIC-S (Note 2) | 6 | 6 | 5 | 5 | 5 | 5 | 5 |
| Irgacure-907 (Note 3) | 3 | 3 | 3 | 3 | 3 | 3 | 3 |
| Kayacure-ITX (Note 4) | 0.5 | 0.5 | 0.5 | 0.5 | 0.5 | 0.5 | 0.5 |
| Modaflow (Note 5) | 1 | 1 | 1 | 1 | 1 | 1 | 1 |
| Silica (mean grain size: 1 µm) | 10 | 7 | 7 | 10 | 15 | 10 | 7 |
| Barium sulfate | 17 | 20 | 20 | 17 | 10 | 17 | 20 |
| Melamine | 1 | 1 | 1 | 1.5 | 1 | 1.5 | 1 |
| Phthalocyanine Green | 0.5 | 0.5 | 0.5 | 0.5 | 0.5 | 0.5 | 0.5 |
| Swazol 1500 (Note 6) | 10 | 7 | 7 | 10 | 10 | 7 | 7 |

| | | | | | | | |
|---|---|---|---|---|---|---|---|
| (Note 2) In Table 2, TEPIC-S is an epoxy resin (having an epoxy equivalent of 100) produced by Nissan Chemical Co. | | | | | | | |
| (Note 3) In Table 2, Irgacure-907 is a photo-polymerization initiator produced by Ciba-Geigy Co. | | | | | | | |
| (Note 4) In Table 2, Kayacure-ITX is a photo-polymerization initiator produced by Nippon Kayaku Co. | | | | | | | |
| (Note 5) In Table 2, Modaflow is a leveling agent produced by Monsant Co. | | | | | | | |
| (Note 6) In Table 2, Swasol 1500 is an aromatic solvent produced by Maruzen Petrochemical Co. | | | | | | | |

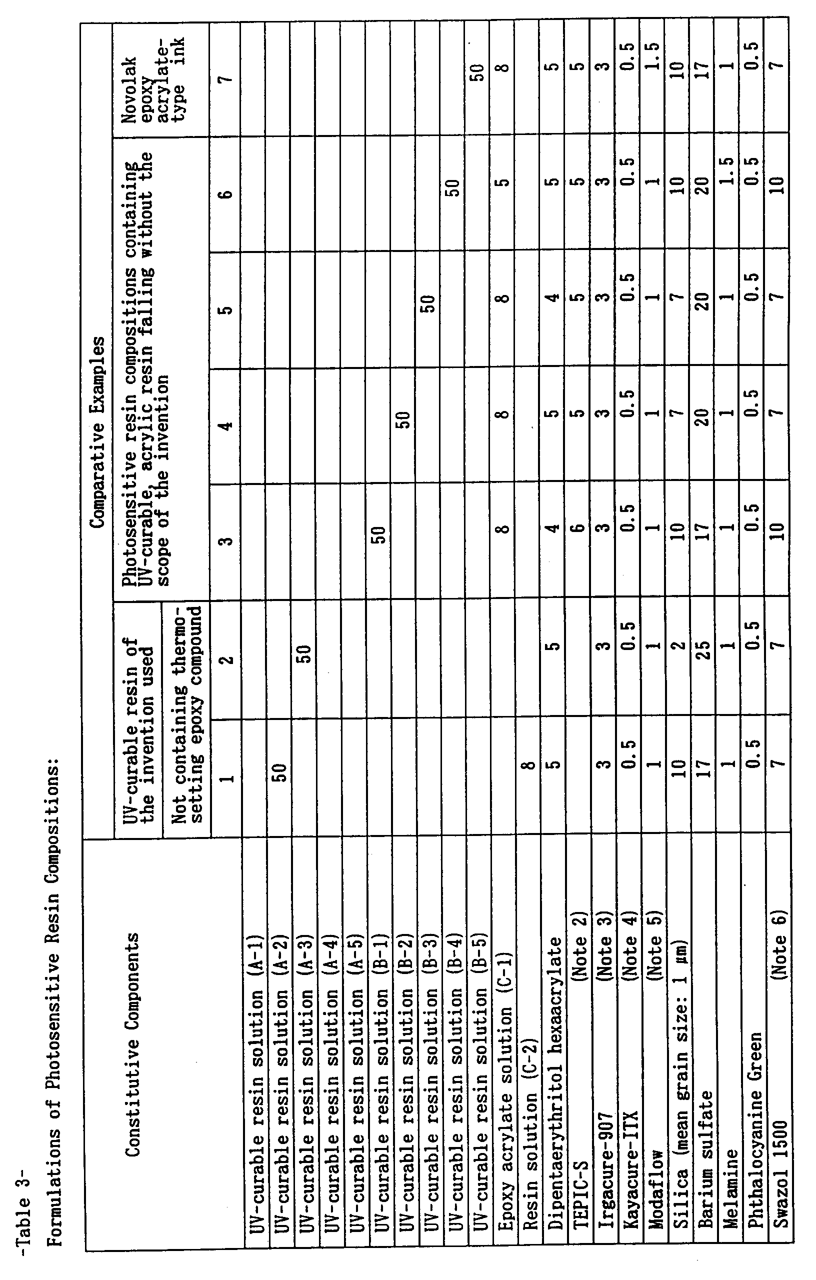

### Evaluation of Properties of Resin Compositions:

The properties of the photosensitive resin compositions of Examples 1 to 7 were evaluated with respect to the matters mentioned below according to the methods also mentioned below, and the results are shown in Table 4. The properties of the photosensitive resin compositions of Comparative Examples 1 to 7 were also evaluated in the same manner, and the results are shown in Table 5.

### -Surface Stickiness-

Each photosensitive resin composition was applied to the whole surface of a copper-laminated glass-epoxy substrate where the copper layer had a thickness of 35 µm, by screen-printing, and then pre-cured by drying at 70°C for 10, 20, 30, 45 or 60 minutes so as to vaporize the solvent. Thus, five test samples each having thereon a dry film with a thickness of 20 µm were prepared for each composition. Next, using an ORC HMW201GX (ex ORC Seisaku-sho Co.; reduced-pressure contact double-side exposing machine), a patterned mask was directly applied to the surface of the film and kept in tight contact therewith under a reduced pressure, and the film was exposed to ultraviolet rays at 150 mJ/cm². After this, the mask was removed from the film, whereupon the degree of stickiness of the film to the mask, depending on the drying condition employed, was determined on the basis of the criteria mentioned below.
X: The removal of the mask was difficult. When the mask was forcedly removed, the mask pattern was broken.
△: After the mask was removed, the mark of the mask remained on the film.
O: The mask was removed easily, and no mark of the mask remained on the film.

### -Latitude in Pre-curing Time-

Each photosensitive resin composition was applied to the whole surface of a copper-laminated glass-epoxy substrate where the copper layer had a thickness of 35 µm, by screen-printing, and then pre-cured by drying at 70°C for 10, 20, 30, 45, 60 or 80 minutes so as to vaporize the solvent. Thus, six test samples each having thereon a dry film with a thickness of 20 µm were prepared for each composition. Next, a patterned mask was directly applied to the surface of the film and kept in tight contact therewith, and the film was exposed to the optimum amount of ultraviolet rays. After this, each sample thus exposed was developed with a developer of a 1 % aqueous solution of sodium carbonate, whereupon the developability of each sample and the condition of the developed pattern were evaluated according to the criteria mentioned below.
X: The removal of even the non-exposed area by the development was difficult, and the patterning was impossible.
△: The removal of even the non-exposed area by the development needed a long period of time, and the patterning of fine lines was impossible.
O: The film in the non-exposed area was easily removed, and a sharp pattern was reproduced.

### -Number of Optical Steps Remained after Development-

Each photosensitive resin composition was applied to the whole surface of a copper-laminated glass-epoxy substrate where the copper layer had a thickness of 35 µm, by screen-printing, and then pre-cured by drying at70°C for 30 minutes so as to vaporize the solvent. Thus, test samples each having thereon a dry film with a thickness of 20 µm were prepared for each composition. Next, using ORC HMW201GX (ex ORC Seisaku-sho Co.; reduced-pressure contact double-side exposing machine), a step tablet PHOTEC 21-Stages (ex Hitachi Kasei Ltd.; mask for exposure test) was directly applied to the surface of the film and kept in tight contact therewith under a reduced pressure, and the film was exposed to ultraviolet rays at 50 or 150 mJ/cm². After this, each sample thus exposed was developed with a developer of a 1 % aqueous solution of sodium carbonate. After the development, the number of the steps remained was counted, which indicates the exposure sensitivity of each sample.

### Evaluation of Properties of Printed Circuit Boards with Solder Resist Formed from Resin Composition:

This is to check the practicability of each photosensitive resin composition prepared above as solder resist ink. Each photosensitive resin composition was applied to the whole surface of a copper-laminated glass-epoxy substrate where the copper layer had a thickness of 35 µm and was previously patterned by etching, by screen-printing. Then, these were pre-cured by drying at 70°C for 20 minutes so as to vaporize the solvent. Thus, test samples each having thereon a dry film with a thickness of 20 µm were prepared for each composition. Next, a patterned mask was directly applied to the surface of the film, and the film was exposed to the optimum amount of ultraviolet rays. After this, each sample thus exposed was developed with a developer of a 1 % aqueous solution of sodium carbonate for patterning, and then cured under heat at 150°C for 30 minutes. Thus using the photosensitive resin compositions prepared in the previous examples and comparative example, prepared were test samples of printed circuit boards.

The results of the evaluation of the test samples of Examples 1 to 7 are shown in Table 4, while those of the test samples of Comparative Examples 1 to 7 are in Table 5. To evaluate the properties of these samples with respect to the matters mentioned below, the samples were subjected to the tests mentioned below.

### -Resolution-

The condition of the pattern to be formed on each test sample through a mask pattern of concentric circles having a solid line width of 40 µm and a line-to-line width of 40 µm was observed according to the criteria mentioned below.
X: No pattern was formed.
△: A pattern was formed but was incomplete in that a part of the pattern disappeared.
O: A sharp pattern was formed.

### -Pencil Hardness-

Using a Mitsubishi Hiuni pencil (ex Mitsubishi Pencil Co.), the pencil hardness of each sample was determined by the ordinary method.

### -Heat Resistance in Soldering (degree of whitening of surface and adhesiveness of film)-

As the flux, used was LONCO 3355-11 (ex London Chemical Co.; water-soluble flux). First, the flux was applied to each test sample, which was then dipped in a solder melt bath at 260°C for 10 seconds. After the sample was washed with water, the degree of whitening of the surface of the sample was determined according to the criteria mentioned below. In addition, each test sample, after having been washed, was subjected to a cross-cut peeling test using an adhesive tape (JIS D0202), whereupon the change, if any, in the adhesiveness of the film was observed according to the criteria mentioned below.

### Degree of Whitening of Surface:

X: The surface was whitened noticeably.
△: The surface was whitened slightly.
O: The surface did not change before and after the test.

### Adhesiveness:

X: Before the peeling test, the resist film blistered or peeled.
△: When the adhesive tape was peeled, some cross-cut parts were also peeled.
O: When the adhesive tape was peeled, the cross-cut parts were not peeled.

### -Other Tests-

The tests for "surface gloss", "solvent resistance", "acid resistance", "gold-plating resistance" and "electro-etching resistance" were conducted according to the ordinary methods.

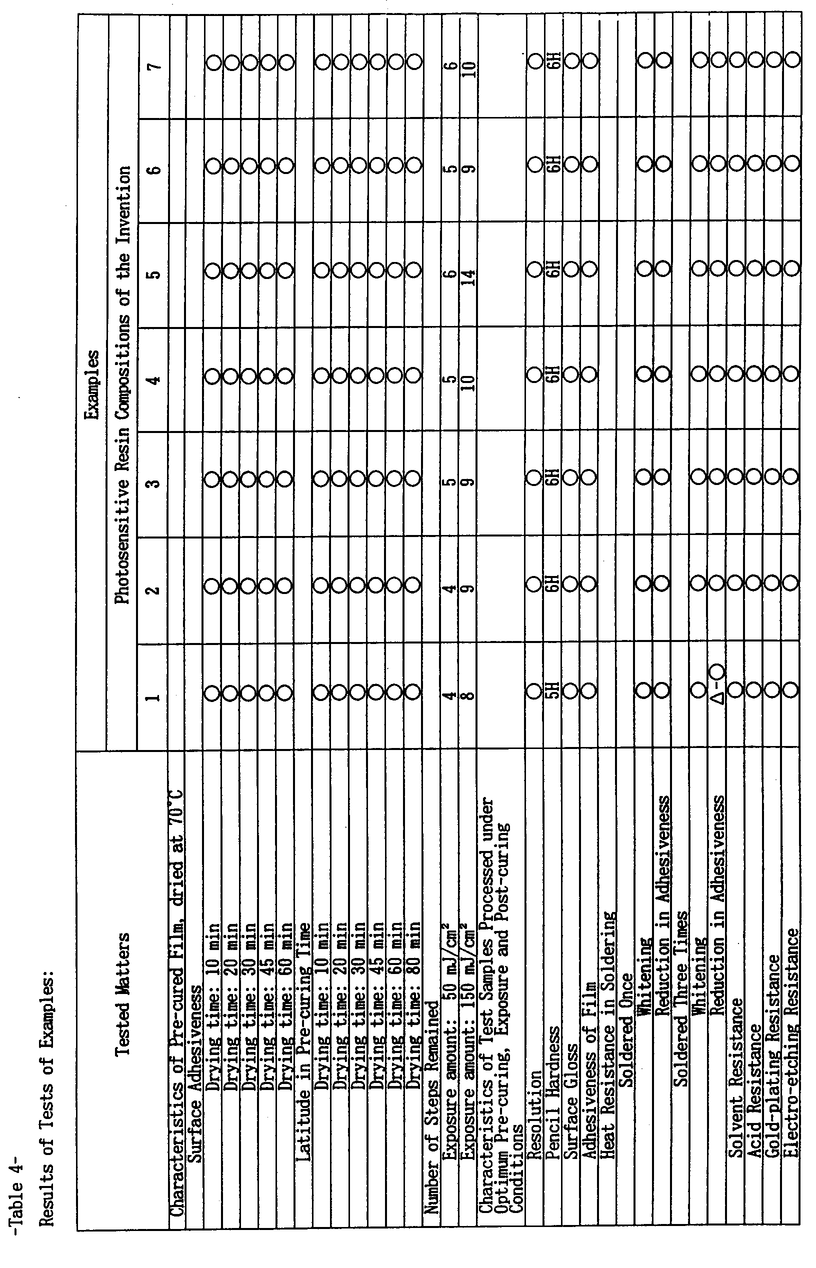

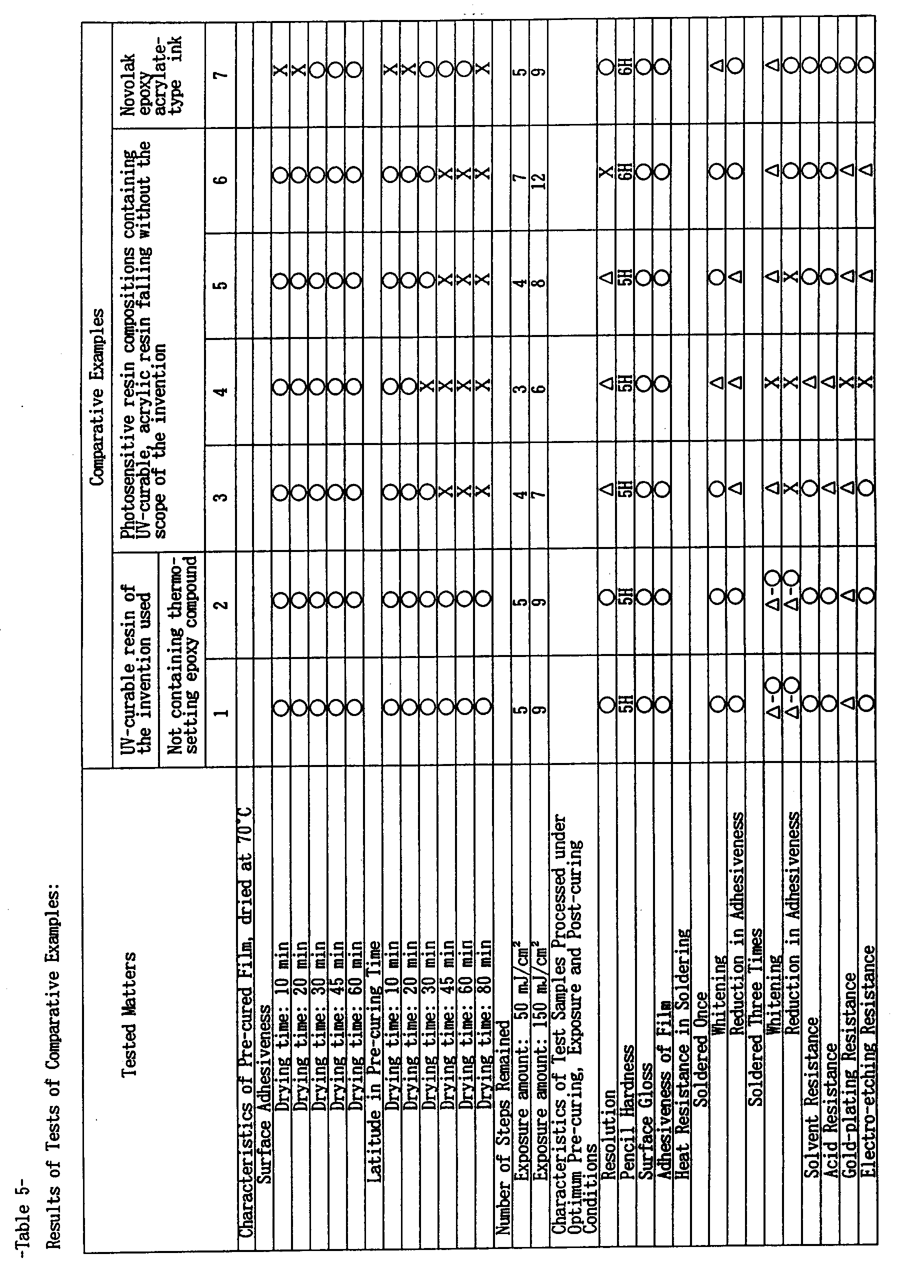

### INDUSTRIAL APPLICABILITY

As has been mentioned hereinabove, the photosensitive resin composition of the present invention is superior to any other conventional ones in the workability in that it has a lot of latitude in pre-curing time, that, in spite of said wide latitude, it has a high sensitivity while being able to be exposed at any desired exposure amount and that it does not need any severe working conditions. In addition, since the film formed from the composition is not sticky even when pre-cured within a short period of time, the working time for the composition is noticeably reduced. Moreover, the photosensitive resin composition of the present invention is stably dispersed by itself, it can be stably stored for a long period of time. The composition gives an excellent film, and when it is used as a resist ink, the resist to be formed from the ink is superior to any other conventional ones in the physical properties in that it has, even though exposed within a short period of time, excellent chemical resistance, solvent resistance and gold-plating resistance. In addition, especially when the composition of the present invention is used to form a solder resist, the solder resist formed has extremely excellent heat resistance in soldering. Due to the characteristics mentioned above, the photosensitive resin composition of the present invention has realized the production of high-quality printed circuit boards at high producibility.

## Claims

1. A photosensitive resin composition which is developable with a dilute, alkaline aqueous solution and which comprises;
A. an ultraviolet-curable resin having a weight-average molecular weight of from 6,000 to 30,000, which is obtained by reacting a polymer comprising (a) from 60 to 100 mol% of glycidyl (meth)acrylate and (b) from 0 to 40 mol% of other ethylenically unsaturated monomer(s) copolymerizable with (a), with from 0.7 to 1.2 chemical equivalents, relative to one epoxy equivalent of the polymer, of (meth)acrylic acid and with a saturated or unsaturated, polybasic acid anhydride,
B. a photo-polymerization initiator,
C. a diluent, and
D. a thermo-setting component.

2. The photosensitive resin composition as claimed in claim 1, wherein the thermo-setting component comprises a thermo-setting epoxy compound.

3. A film formed from the photosensitive resin composition of claim 1 or 2, on a substrate.

4. A resist ink for producing printed circuit boards, comprising the photosensitive resin composition of claim 1 or 2.

5. A resist formed from the resist ink of claim 4, on a substrate.

6. A solder resist formed from the resist ink of claim 4, on a substrate.

7. A printed circuit board produced by using the resist ink of claim 4.
